# EUROPEAN PATENT SPECIFICATION

(11) **EP 4 129 146 B1**
(45) Date of publication and mention of the grant of the patent: **25.09.2024**
(21) Application number: 22186824.3
(22) Date of filing: 26.07.2022
(51) Int. Cl.: A47L 15/42, A47L 15/48

(54) **DISHWASHER**
GESCHIRRSPÜLER
LAVE-VAISSELLE

(30) Priority: 03.08.2021 KR 20210102065
(43) Date of publication of application: 08.02.2023
(73) Proprietor: LG Electronics Inc., Seoul 07336 (KR)
(72) Inventor: KIM, Jongyoung, 08592 Seoul (KR); LEE, Dongho, 08592 Seoul (KR); KIM, Kyung Rae, 08592 Seoul (KR); KIM, Doo Hyun, 08592 Seoul (KR); BAEK, In Woo, 08592 Seoul (KR)
(74) Representative: Vossius & Partner Patentanwälte Rechtsanwälte mbB

(56) References cited:
- EP-A1- 3 524 127
- WO-A1-2019/192887
- CN-A- 111 728 565
- DE-C2- 4 029 958
- KR-Y1- 200 440 769

## Description

### TECHNICAL FIELD

Disclosed herein is a dishwasher, and in particular, a dishwasher with an air supply device.

### BACKGROUND

Details in the background section do not constitute a prior art but are given only as background information concerning the subject matter of the present disclosure.

Dishwashers are devices that sprays water to objects to be washed such as cooking vessels, cooking tools and the like stored therein and wash them. In this case, detergent can be included in wash water used for a wash.

Ordinary dishwashers include a wash tub forming wash space, a storage part accommodating objects to be washed in the wash tub, a spray arm spraying wash water into the storage part, and a sump storing wash water and supplying wash water to the spray arm.

Dishwashers help users to spend less time and efforts washing the dishes after meals, improving user convenience.

Dishwashers can be provided with a structure spraying air to objects to be washed to rapidly dry the objects to be washed after a wash process in which wash water is used.

A dishwasher having a structure that allows air to flow in wash space is disclosed in KR Patent Publication No. 10-2017-0011702.
EP 3 524 127 A1 relates to a dishwasher including: a cabinet defining an external appearance of the dishwasher; a tub disposed in the cabinet to form a space where to wash dishes; a heat exchange module disposed between the tub and the cabinet to form a space in which external air flows, and configured to supply the external air to the tub; and a condensing module disposed between the heat exchange module and the cabinet and configured to perform heat exchange of air discharged from the tub with the external air flowing in the heat exchange module and discharge heat-exchanged air to an outside of the cabinet.

### SUMMARY

A dishwasher needs to have an air spraying structure and an air supply device that smoothly spray air into a tub where objects to be washed are stored, and occupy less space in the tub.

A door provided for the dishwasher may rotate with respect to the dishwasher to be opened and closed. When the door is opened and closed, the position of the center of mass of the entire dishwasher may change, causing the overturning of the dishwasher.

To prevent this from happening, the dishwasher requires a structure that prevents the overturning the dishwasher even when the position of the center of mass of the dishwasher changes.

Additionally, a control module may be provided to control operations of an air supply device provided in the dishwasher. If the control module is disposed in the lower portion of the dishwasher, the control module may be submerged. This problem needs to be solved.

Further, a heating part may be provided in the air supply device, to spray heated air, i.e., hot air, into the tub. In this case, a structure that suppresses the transfer of heat generated in the heating part to the control module is required to prevent the control module from overheating.

Furthermore, a structure that supplies air for cooling to the control module is required to suppress the overheating of the control module.

In this context, the objective of the present invention is to provide a dishwasher having a structure in which an air supply device provided in the dishwasher serves as a balance weight that suppresses the overturning of the dishwasher.

Another objective of the present invention is to provide a dishwasher having a structure which suppresses the submergence of a control module controlling operations of the air supply device.

Yet another objective of the present invention is to provide a dishwasher having a structure which suppresses the overheating of the control module controlling operations of the air supply device and supplies air for cooling to the control module.
The invention is set out in the appended set of claims. Any references in the following description to embodiments, objects, aspects and/or examples which are not covered by the appended claims are considered as not being part of the present invention.

The aspects and advantages in the present invention can be realized via means and combinations thereof that are described in the appended claims.

A base is disposed under a tub, and the tub may be mounted on the base. A door may be rotatably coupled to the base, and opens and closes wash space. To this end, the door may be provided with a hinge coupling part that is disposed at the front of the base, and allows the door to be rotatably hinge-coupled to both sides of the front of the base.

A sump is disposed under the tub and mounted on the base and store wash water. The sump may be disposed behind the door. The dishwasher further includes an air supply device that is mounted on the base and sprays air to the tub.

The door is coupled to the base in front of the sump in the front-rear direction of the base. The air supply device is disposed behind the sump in the front-rear direction of the base.

The lengthwise direction of the air supply device may be parallel with the lateral direction of the base.

The dishwasher further includes an air supply control module. The air supply control module is be disposed in the base, electrically connect to the air supply device, and controls operations of the air supply device.

The dishwasher in the embodiment may further include a main control module. The main control module may be disposed in the lateral portion of the base and electrically connect to the air supply control module.

The dishwasher in the embodiment may further include a balance weight. The balance weight may be disposed behind the sump, disposed on the base, and suppress the overturning of the dishwasher, caused by a rotation of the door.

The balance weight may be mounted on the base in a way that the balance weight is spaced from the air supply device in the lateral direction of the base. Additionally, the balance weight may be disposed in front of the air supply control module.

The base may include a bottom plate. The bottom plate may form the bottom of the base. The air supply control module may be disposed on a wall over a bottom plate (81) of the base (8) and so it may be configured to be spaced from the bottom plate (81).

The wall may include a first wall, a second wall and a rear wall. The first wall may be formed in a way that at least a portion of the first wall bends from the bottom plate in the up-down direction.

The second wall may be formed in a way that at least a portion of the second wall bends from the first wall in the front-rear direction, and the air supply control module may be mounted on the second wall. The rear wall may be formed in a way that at least a portion of the rear wall bends from the second wall in the up-down direction.

The second wall may include a flat part, a first connection part and a second connection part. The flat part may have an upper surface which is formed in a parallel direction with the front-rear direction and the left-right direction of the base and on which the lower surface of the air supply control module is placed. The flat part may have a first fastening hole into which a coupling tool for a coupling with the air supply control module is inserted.

The rear wall may include a coupling protrusion part. The coupling protrusion part may protrude forward from the rear wall and contact one surface of the air supply control module. The coupling protrusion part may have a second fastening hole into which a coupling tool for a coupling with the air supply control module is inserted.

The air supply device may spray air into the tub to dry objects to be washed that are accommodated in the tub. The air supply device may include a housing, an air blowing fan and an air discharge part.

The housing may have a flow path through which air flows. The air blowing fan may be mounted in the housing and force air flowing into the housing to flow. The air blowing fan may include an air inlet into which external air flows. The air inlet may be formed to allow air to flow into the housing in a parallel direction with the rotation axis of the air blowing fan.

A heating part may be disposed in the housing at least partially and heat air forced to flow by the air blowing fan. The heating part may be built into the housing, and air forced to flow by the air blowing fan may be heated by the heating part to become hot air while flowing in the housing.

The air discharge part may be mounted in the housing, communicate with an air outlet of the housing, and guide the flow of air being discharged from the tub.

The air inlet of the air blowing fan may be disposed to overlap the air supply control module in the front-rear direction of the base. The air supply control module may have a vent hole, on the front surface thereof.

The air inlet of the air blowing fan may be formed to face the front of the base. Accordingly, the air blowing fan may force external air to flow in the front-rear direction of the base, and allow the air to be suctioned into the air inlet.

Air near the air blowing fan may flow in the front-rear direction of the base as the air blowing fan operates, and a portion of the air, forced to flow by the air blowing fan in the front-rear direction of the base, may flow into the vent hole of the air supply control module.

A dishwasher of one embodiment may include a tub forming wash space and accommodating objects to be washed, a base being disposed under the tub and having the tub mounted thereon, a door being rotatably coupled to the base and opening and closing the wash space, a sump being mounted on the base and storing wash water, and an air supply device being mounted on the base and spraying air to the tub, the door may be coupled to the base, in front of the sump, in the front-rear direction of the base, and the air supply device may be disposed behind the sump in the front-rear direction of the base.

A dishwasher of another embodiment may include a tub forming wash space and accommodating objects to be washed, a base being disposed under the tub and having the tub mounted thereon, a door being rotatably coupled to the base and opening and closing the wash space, a sump being mounted on the base, being disposed behind the door, and storing wash water, an air supply device being mounted on the base, being disposed behind the sump, and spraying air to the tub, a balance weight being mounted on the base, being disposed behind the sump, and being spaced from the air supply device, and an air supply control module being disposed behind the air supply device, being spaced from the air supply device, and controlling operations of the air supply device.

In the dishwasher of the present invention, the air supply device and the air supply control module may serve as a balance weight that counters the door. Accordingly, even when the opening of the door results in the movement of the center of mass of the entire dishwasher to the front of the base due to the mass of the door, the air supply device and the air supply control module may suppress the excessive forward movement of the center of mass of the dishwasher.

Thus, the air supply device and the air supply control module may suppress the overturning of the dishwasher effectively when the door is opened.

In the dishwasher of the present invention, the air supply control module is disposed over a bottom plate of the base and spaced from the base. In the structure, wash water collected on the bottom plate of the base may be prevented from flowing into the air supply control module disposed at the upper side of the bottom plate, readily suppressing the submergence of the air supply control module.

In the dishwasher of the present invention, since the air supply device and the air supply control module are separated and spaced from each other in the front-rear direction of the base, the overheating of the air supply control module, caused by a direct transfer of heat generated in the heating part provided in the housing of the air supply device to the air supply control module, may be suppressed effectively.

In the dishwasher of the present invention, since the air supply control module and the air blowing fan may be disposed to overlap each other in the front-rear direction of the base, a portion of air forced to flow by the air blowing fan may flow into the air supply control module and cool the components in the air supply control module, effectively suppressing the overheating of the air supply control module, which is caused when the dishwasher operates.

Specific effects are described along with the above-described effects in the section of detailed description.

### BRIEF DESCRIPTION OF DRAWINGS

The accompanying drawings constitute a part of the specification, illustrate one or more embodiments in the invention, and together with the specification, explain the disclosure, wherein:
FIG. 1 is a schematic cross-sectional view showing a dishwasher of one embodiment;
FIG. 2 is a perspective view showing a base of one embodiment;
FIG. 3 is a plan view showing the base of one embodiment;
FIG. 4 is a view of FIG. 2 without a sump;
FIG. 5 is a plan view of FIG. 4;
FIG.6 is a cross-sectional view showing portion AA of FIG. 5
FIG. 7 is a view of FIG. 5without an air supply control module;
FIG. 8 is a cross-sectional view showing portion BB of FIG. 7;
FIG. 9 is an exploded perspective view showing an air supply device of one embodiment;
FIG. 10 is a front view showing the air supply device of one embodiment;
FIG. 11 is a cross-sectional view showing portion CC of FIG. 10; and
FIG. 12 is a view showing that some components in FIG. 4 are disassembled.

### DETAILED DESCRIPTION

The above-described aspects, features and advantages are specifically described hereafter with reference to the accompanying drawings such that one having ordinary skill in the art to which the present invention pertains can embody the disclosure easily. In the disclosure, detailed description of known technologies in relation to the disclosure is omitted if it is deemed to make the gist of the disclosure unnecessarily vague. Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "include" and the like, set forth herein, are not interpreted as necessarily including all the stated components or steps but can be interpreted as excluding some of the stated components or steps or can be interpreted as including additional components or steps.

Throughout the disclosure, the terms "A and/or B" as used herein can denote A, B or A and B, and the terms "C to D" can denote C or greater and D or less, unless stated to the contrary.

Throughout the disclosure, an "up-down direction" denotes the up-down direction of a dishwasher in a state in which the dishwasher is installed for use. A "left-right direction" denotes a direction orthogonal to the up-down direction, and a "front-rear direction" denotes a direction orthogonal to the up-down direction and the left-right direction. "Both lateral directions" or a "lateral direction" can have the same meaning as the left-right direction. These terms can be mixedly used in the disclosure.

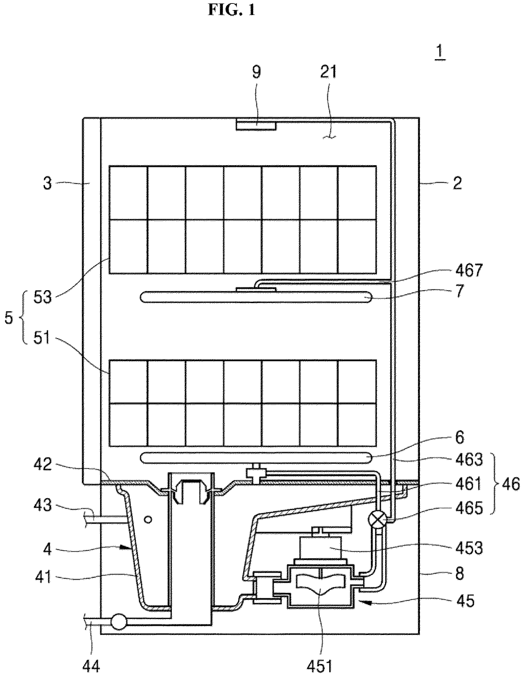

FIG. 1 is a schematic cross-sectional view showing a dishwasher 1 of one embodiment.

Referring to FIG. 1, the dishwasher 1 may include a housing forming the exterior of the dishwasher 1, a tub 2 forming a wash space 21 in the housing and accommodating an object to be washed, a door 3 rotatably being coupled to the base 8 and selectively opening and closing the wash space 21, a sump 4 being disposed under the tub 2 and storing wash water, a storage part 5 being disposed in the tub 2 and storing an object to be washed, and spray arms 6, 7, 9 spraying wash water to an object to be washed being stored in the storage part 5. The object to be washed may be cooking vessels such as a bowl, a dish, a spoon, chop sticks and the like, and other cooking tools, for example.

The tub 2 may form the wash space 21 and accommodate cooking vessels, and the storage part 5 and the spray arms 6, 7, 9 may be provided in the wash space 21. The tub 2 has a shape in which one surface is open, and the open one surface may be opened and closed by the door 3.

The door 3 may swivably connect to the housing, and selectively open and close the wash space 21. For example, the lower portion of the door 3 may be hinge-coupled to the housing.

In this case, the door 3 may rotate around a hinge, and open and close the tub 2. When the door 3 is opened, the storage part 5 may be withdrawn out of the dishwasher 1, and the storage part 5 withdrawn outward may be supported by the door 3.

The sump 4 may include a storage part 41 storing wash water, a sump cover 42 distinguishing the storage part 41 from the tub 2, a water supply part 43 supplying wash water to the storage part 41 from the outside, a water discharge part 44 discharging wash water of the storage part 41 outward, and a water supply pump 45 and a supply channel 46 that are used to supply wash water of the storage part 41 to the spray arms 6, 7, 9.

The sump cover 42 may be disposed on the sump 4, and distinguish the tub 2 from the sump 4. Additionally, the sump cover 42 may be provided with a plurality of return holes for returning wash water having sprayed to the wash space 21 through the spray arms 6, 7, 9.

That is, wash water having sprayed from the sprays arms 6, 7, 9 may fall to the lower portion of the wash space 21, pass through the sump cover 42, and return to the storage part 41 of the sump 4.

The water supply pump 45 may be disposed in a lateral portion or the lower portion of the storage part 41, and supply wash water to the spray arms 6, 7, 9.

One end of the water supply pump 45 may connect to the storage part 41, and the other end may connect to the supply channel 46. The water supply pump 45 may have an impeller 451, a motor 453 and the like, therein. As the motor 453 is supplied with power, the impeller 451 may rotate, and wash water in the storage part 41 may be supplied to the spray arm 6, 7, 9 through the supply channel 46.

The supply channel 46 may selectively supply wash water supplied from the water supply pump 45 to the spray arm 6, 7, 9.

The supply channel 46 may include a first supply channel 461 connecting to a lower spray arm 6, a second supply channel 463 connecting to an upper spray arm 7 and a top nozzle 9, and a supply channel diverting valve 465 selectively opening and closing the supply channels 461, 467. The supply channel diverting valve 465 may control the supply channels 461, 463 such that each of the supply channels 461, 463 is opened consecutively or simultaneously.

At least one of storage parts 5 for storing cooking vessels may be provided in the wash space 21. The dishwasher 1 is provided with two storage parts 2, in FIG. 1, but not limited.

For example, the dishwasher 1 may include a single storage part or three or more of storage parts. The number of the spray arms may vary depending on the number of the storage parts.

The storage part 5 may include a lower rack 51 and an upper rack 53 that are used for storing cooking vessels. The lower rack 51 may be disposed in the wash space 21 and store cooking vessels. The upper rack 53 may be disposed over the lower rack 51 and store cooking vessels. A top rack may be disposed in a space between the upper side of the upper rack 53 and the top nozzle 9, and store cooking vessels.

The lower rack 51 may be disposed over the sump 4, and the upper rack 53 may be disposed further upward than the lower rack 51. The lower rack 51 and the upper rack 53 and the top rack may be withdrawn outward through one open surface of the tub 2.

To this end, a rail-type holder is disposed on the inner circumferential surface of the tub 2, and a wheel may be provided under the racks 51, 53. A user may withdraw the storage part 5 outward, to sore cooking vessels or take out cooking vessels having cleaned.

The spray arms may be disposed in the tub 2 and spray wash water toward cooking vessels in the storage part 5. The spray arms may include a lower spray arm 6, an upper spray arm 7 and a top nozzle 9.

The lower spray arm 6 may be rotatably provided at the lower side of the lower rack 51, and spray wash water to cooking vessels. The upper spray arm 7 may be rotatably provided between the lower rack 51and the upper rack 53, and spray wash water to cooking vessels.

The lower spray arm 6 may be rotatably mounted on the sump cover 42 and spray wash water to cooking vessels stored in the lower rack 51. The upper spray arm 7 may be disposed over the lower spray arm 6 and spray wash water to cooking vessels stored in the upper rack 53. The top nozzle 9 may be disposed in the upper portion of the wash space 21 and spray wash water to the lower rack 51 and the upper rack 53.

As described above, the first supply channel 461 may supply wash water to the lower spray arm 6, and the second supply channel 463 may supply wash water to the upper spray arm 7 and the top nozzle 9.

Referring to FIG. 1, the dishwasher 1 may include a base 8. The base 8 may be disposed under the tub 2, and the tub 2 may be mounted on the base 8. The base 8 may provide space accommodating the sump 4, and accommodating a pump, an air supply device 100, and various types of devices provided for the dishwasher 1.

The base 8 may support the dishwasher 1 entirely with its outer walls, and the space in which various types of devices are accommodated may be formed by the outer wall.

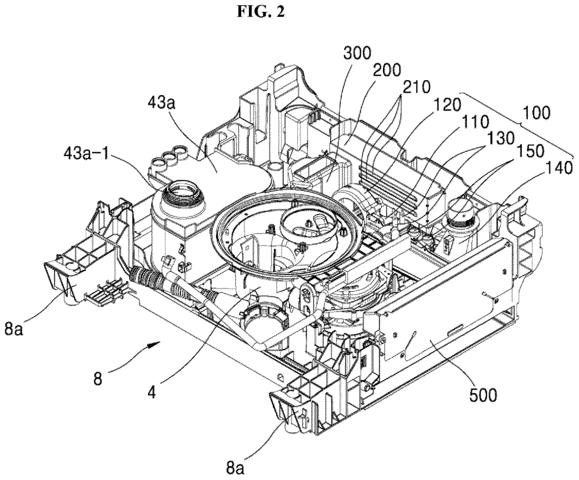

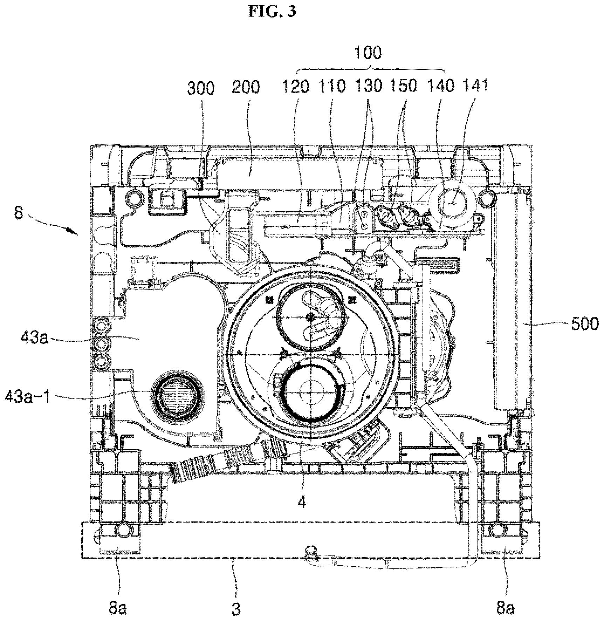

FIG. 2 is a perspective view showing a base 8 of one embodiment. FIG. 3 is a plan view showing the base 8 of one embodiment.

The base 8 may be disposed under the tub 2, and the tub 2 may be mounted on the base 8. The door 3 may be rotatably coupled to the base 8, and open and close the wash space. To this end, the door 3 may be provided with a hinge coupling part 8a that is disposed at the front of the base 8, and allows the door 3 to be rotatably hinge-coupled to both sides of the front of the base 8.

A water supply tank 43a may be disposed in the base 8. The water supply tank 43a may be mounted on the base 8, communicate with the tub 2 and connect to the water supply part 43 supplying wash water. Wash water may be temporarily stored in the water supply tank 43a through the water supply part 43, and flow into the tub 2 again and be stored in the sump 4.

The water supply tank 43a may be provided with a filter 43a-1 that removes foreign substances included in wash water flowing into the tub 2. Additionally, the water supply tank 43a may be provided with a water softener that changes wash water from hard water to soft water.

The sump 4 may be disposed under the tub 2 mounted on the base 8 and store wash water. The sump 4 may be disposed behind the door 3. The dishwasher 1 may further include an air supply device 100 that is mounted on the base 8 and sprays air to the tub 2. The air supply device 100 may be disposed behind the sump 4.

The door 3 may be coupled to the base 8 in front of the sump 4 in the front-rear direction of the base 8. The air supply device 100 may be disposed behind the sump 4 in the front-rear direction of the base 8.

Since the door 3 and the air supply device 100 may be disposed respectively at the front and at the rear of the dishwasher 1 with respect to the sump 4, the door 3 and the air supply device 100 may be spaced from each other in the front-rear direction of the dishwasher 1.

The lengthwise direction of the air supply device 100 may be parallel with the lateral direction of the base 8. The air supply device 100 may be disposed behind the sump 4, i.e., at the rear of the base 8, and spaced from the door 3 disposed at the frontmost side of the base 8 in the front-rear direction of the base 8.

The dishwasher 1 may further include an air supply control module 200. The air supply control module 200 may be disposed in the base 8, electrically connect to the air supply device 100 and control the operation of the air supply device 100.

The air supply control module 200 may be disposed behind the air supply device 100 and spaced from the air supply device 100, and disposed over the bottom plate 81 of the base 8 and spaced from the bottom plate 81. The disposition structure of the air supply control module 200 is specifically described hereafter.

The air supply control module 200 may be entirely formed into an approximately rectangular cuboid shape. The air supply control module 200 may be provided with at least one circuit board, and various types of active elements and passive elements that are mounted on the circuit board.

The air supply control module 200 may be disposed behind the air supply device 100 and spaced from the air supply device 100, and the lengthwise direction of the air supply control module 200 may be parallel with the lateral direction of the base 8.

Accordingly, the air supply control module 200 may be disposed behind the air supply device 100, i.e., the rearmost side of the base 8, and spaced from the door 3 disposed at the frontmost side of the base 8 in the front-rear direction of the base 8.

The air supply device 100 and the air supply control module 200 may have a predetermined mass, and as described above, may be disposed near the rear end of the base 8, and the lengthwise directions of the air supply device 100 and the air supply control module 200 may be parallel with the lateral direction of the base 8.

In the structure, the air supply device 100 and the air supply control module 200 may help to significantly increase mass at the rear of the base 8, serving as a balance weight that counters the door 3 disposed at the frontmost side of the base 8.

When the door 3 of the dishwasher 1 is opened, since the center of mass of the dishwasher 1 moves to the portion where the door 3 is disposed, i.e., the front of the dishwasher 1, due to the mass of the door 3, the dishwasher 1 is likely to fall forward. To prevent the dishwasher 1 from overturning, a balance weight 300 described hereafter may be mounted on the base 8.

In the dishwasher 1 of the embodiment, the air supply device 100 and the air supply control module 200 may serve as a balance weight that counters the door 3. Accordingly, even when the opening of the door 3 results in the forward movement of the center of mass of the entire dishwasher 1 to the front of the base 8 due to the mass of the door 3, the air supply device 100 and the air supply control module 200 may suppress the excessive forward movement of the center of mass of the dishwasher 1.

Thus, the air supply device 100 and the air supply control module 200 may effectively suppress the overturning of the dishwasher 1 when the door 3 is opened.

The dishwasher 1 in the embodiment may further include a main control module 500. The main control module 500 may be disposed in the lateral portion of the base 8 and electrically connect to the air supply control module 200.

The main control module 500 may control the operations of the entire dishwasher 1 including the air supply device 100 and the air supply control module 200. The main control module 500 may be disposed in the lateral portion of the base 8 such that the user approaches the board, elements and the like in the main control module 500 to replace and repair them readily, and the inside of the main control module 500 may be opened and closed easily.

The dishwasher 1 in the embodiment may further include a balance weight 300. However, if the above-described air supply device 100 and air supply control module 200 can suppress the overturning of the dishwasher 1 sufficiently, the dishwasher 1 may not be provided with the balance weight 300.

The balance weight 300 may be disposed behind the sump 4, mounted on the base 8, and suppress the overturning of the dishwasher 1 caused by the rotation of the door 3. The balance weight 300 may have a predetermined mass, and be made of various types of materials.

The balance weight 300 may be mounted on the base 8 in a way that the balance weight 300 is spaced from the air supply device 100 in the lateral direction of the base 8. Additionally, the balance weight 300 may be disposed in front of the air supply control module 200.

However, the position of the balance weight 300 is not limited. The balance weight 300 may be disposed in a different position having proper space for mounting itself, as long as the balance weight 300 suppresses the overturning of the dishwasher 1 when the door 3 is opened. Additionally, the balance weight 300 may have a different shape.

Since the air supply device 100 and the air supply control module 200 suppresses the overturning of the dishwasher 1 as described above, the balance weight 300 may not be provided in the dishwasher 1. Further, even if the balance weight 300 is provided, the cost of manufacturing the balance weight 300 may decrease, and the space occupied by the balance weight 300 may decrease effectively, since the mass and volume of the balance weight 300 can decrease significantly.

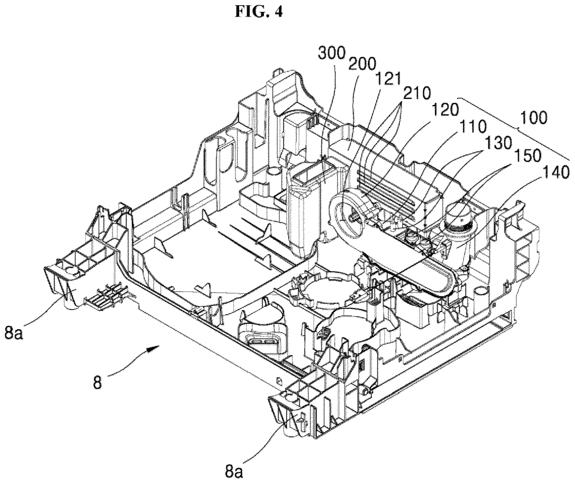

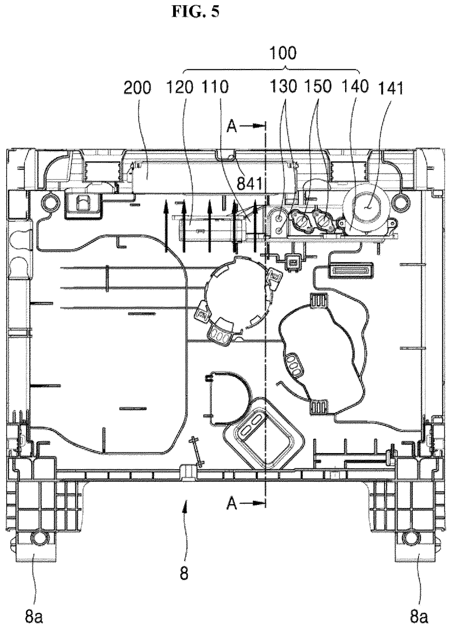

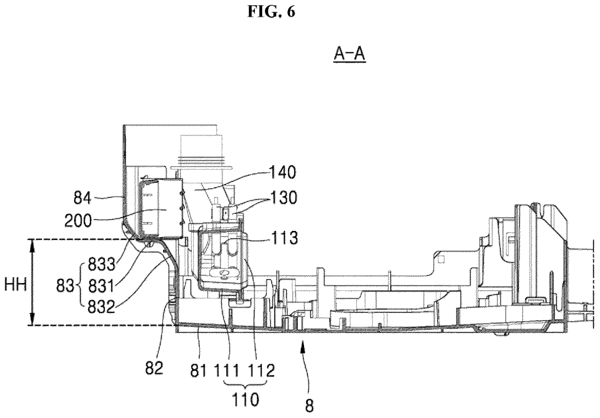

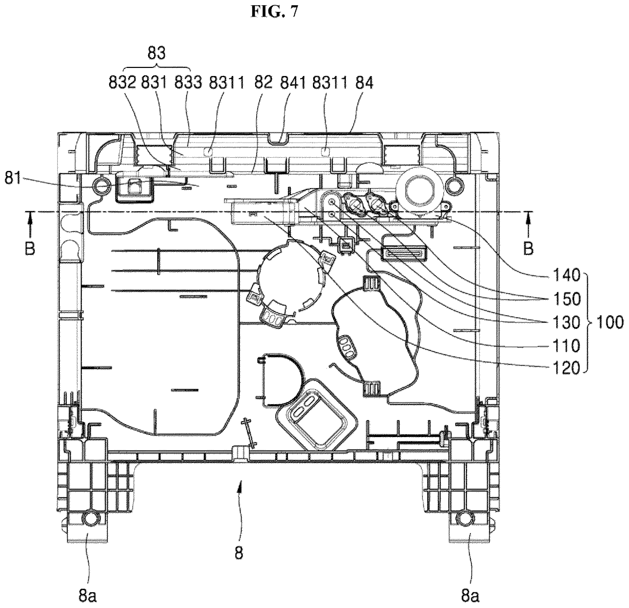

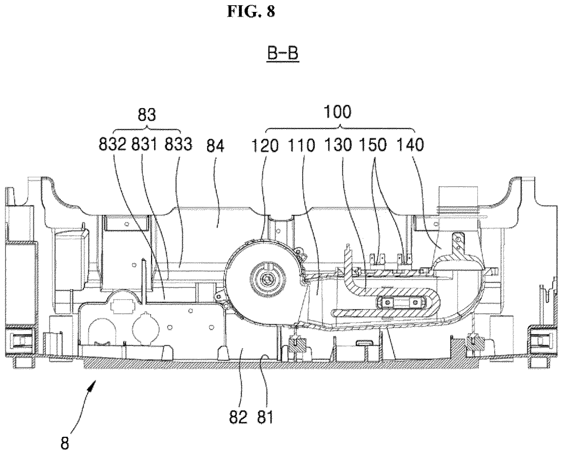

FIG. 4 is a view of FIG. 2 without a sump 4. FIG. 5 is a plan view of FIG. 4. FIG.6 is a cross-sectional view showing portion AA of FIG. 5. FIG. 7 is a view of FIG. 5 without an air supply control module 200. FIG. 8 is a cross-sectional view showing portion BB of FIG. 7.

The base 8 may include a bottom plate 81. The bottom plate 81 may form the bottom of the base 8. The air supply control module 200 may be disposed on a wall over the bottom plate 81 of the base 8 and so it may be configured to be spaced from the bottom plate 81.

The wall may include a first wall 82, a second wall 83 and a rear wall 84. The first wall 82 may be formed in a way that at least a portion of the first wall 82 bends from the bottom plate 81 in the up-down direction.

The second wall 83 may be formed in a way that at least a portion of the second wall 83 bends from the first wall 82 in the front-rear direction, and the air supply control module 200 may be mounted on the second wall 200. The rear wall 84 may be formed in a way that at least a portion of the rear wall 84 bends from the second wall 83 in the up-down direction.

The rear wall 84 may form the rear surface of the base 8. The second wall 83 may connect to the rear wall 84 and disposed at the rear of the base 8. Accordingly, the air supply control module 200 mounted on the second wall 83 may be disposed at the rearmost side of the base 8 and serve as a balance weight that counters the mass of the door 3.

The second wall 83 may include a flat part 831, a first connection part 832 and a second connection part 833.The first connection part 832 may connect the first wall 82 and the flat part 831, and in a cross section, at least a portion of the first connection part 832 is at a slant with respect to the up-down direction of the base 8. The second connection part 833 may connect the rear wall 84 and the flat part 831, and in a cross section, at least a portion of the second connection part 833 may be at a slant with respect to the up-down direction of the base 8, like the first connection part 832.

The flat part 831 may have an upper surface that is formed in a parallel direction with the front-rear direction and the left-right direction of the base 8, and the lower surface of the air supply control module 200 may be placed on the upper surface of the flat part 831. The flat part 831 may have a first fastening hole 8311 into which a coupling tool for a coupling with the air supply control module 200 is inserted. The coupling tool may be a screw bolt, for example, but not limited.

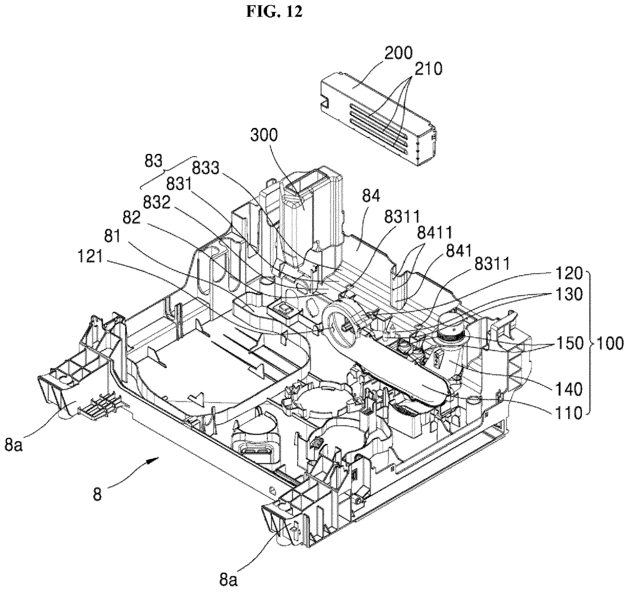

The rear wall 84 may include a coupling protrusion part 841. The coupling protrusion part 841 may protrude forward from the rear wall 84 and contact one surface of the air supply control module 200. The coupling protrusion part 841 may have a second fastening hole 8411 (see FIG. 12) into which a coupling tool for a coupling with the air supply control module 200 is inserted.

The air supply control module 200 may be coupled to each coupling tool of the flat part 831 and the rear wall 84 and sit in the base 8 stably.

Since the flat part 831 is spaced from the bottom plate 81 in the up-down direction, the air supply control module 200 mounted on the upper surface of the flat part 831 may be spaced upward from the bottom plate 81 of the base 8.

The bottom plate 81 of the base 8 and the flat part 831 of the base 8 may be spaced from each other by distance HH in the up-down direction of the base 8, as illustrated in FIG. 6, and the air supply control module 200 may be spaced upward from the bottom plate 81 by distance HH.

The sump 4 storing wash water may be disposed at the base 8, and at least a portion of a supply device for supplying wash water from the outside may be disposed at the base 8. Since the base 8 is disposed under the tub 2, and a portion of wash water spraying into the tub 2 may come into the base 2 because of gravity.

For this reason, when wash water leaks from each of the components, the tub 2 and the like of the dishwasher 1, the wash water may flow into and be collected on the bottom plate 81 of the base 8. To prevent this from happening, a wash water detection device may be provided at the base 8, in the form of a floater, to detect whether wash water flows into the bottom plate 81.

If wash water is collected in the base 8, the main control module 500 and the air supply control module 200, mounted in the base 8, may be submerged in the wash water. To suppress the submergence of the main control module 500, a partition wall may be formed between the main control module 500 and the base 8.

Since a portion of the main control module 500 is exposed outward, to install the partition wall for suppressing submergence in the main control module 500 is easier than to install the partition wall in the air supply control module 200.

Unlike the main control module 500, the air supply control module 200 is entirely mounted in the base 8. Accordingly, it is difficult to reserve space for installing the partition wall and provide a stereoscopic partition wall in the air supply control module 200. Thus, the partition wall for suppressing submergence cannot be installed readily.

In the embodiment, the air supply control module 200 may be spaced upward from the bottom plate 81 of the base 8. In the structure, wash water collected on the bottom plate 81 of the base 8 is prevented from flowing into the air supply control module 200 disposed over the bottom plate 81, such that the submergence of the air supply control module 200 is suppressed readily.

The distance, i.e., distance HH in FIG. 6, may be determined, considering the entire volume of the dishwasher 1, the volume of the base 8, the size of the inner space of the base 8, a predicted amount of wash water flowing into the base 8 caused by the leakage of wash water and the like.

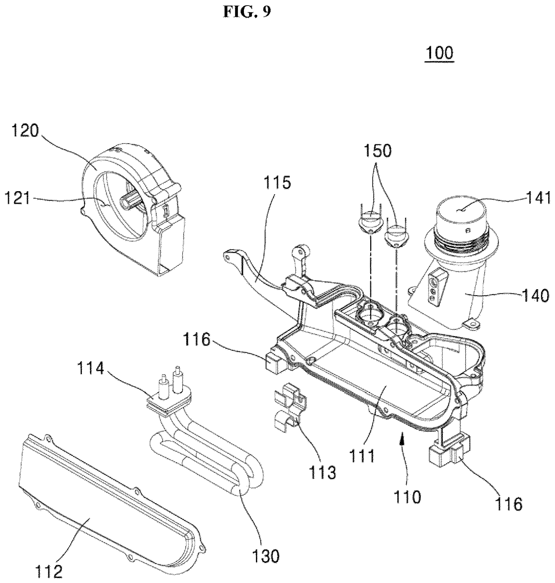

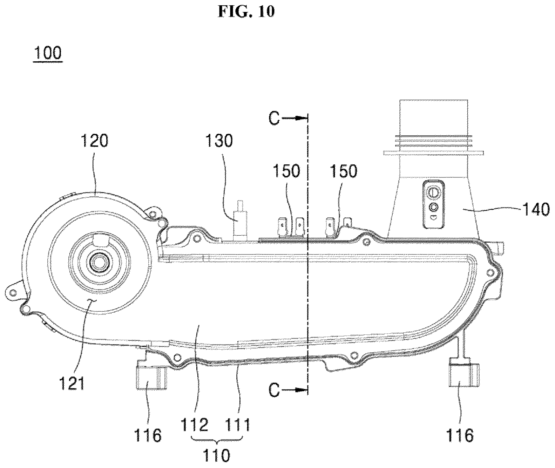

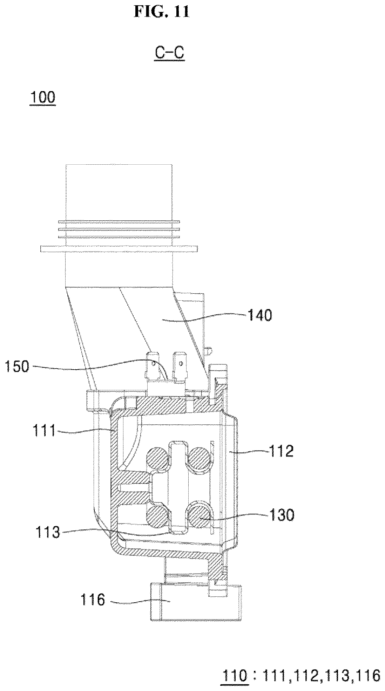

FIG. 9 is an exploded perspective view showing an air supply device 100 of one embodiment. FIG. 10 is a front view showing the air supply device 100 of one embodiment. FIG. 11 is a cross-sectional view showing portion CC of FIG. 10.

The air supply device 100 may be separated and spaced from the air supply control module 200 in the front-rear direction of the base 8. The air supply device 100 may be provided with a heating part 130, and may suppress the overheating of the air supply control module 200, caused by the transfer of heat generated in the heating part 130 to the air supply control module 200.

The air supply device 100 may be mounted on the base 8, communicate with the tub 2 and spray air to the tub 2. The air supply device 100 may spray air into the tub 2 to dry objects to be washed accommodated in the tub 2.

The air supply device 100 may spray cold air that is an unheated air flow or hot air that is a heated air flow. The air supply device 100 may spray cold air or hot air into the tub 2, as a result of control over the operation of the heating part 130 provided in the air supply device 100.

In the state in which the heating device does not operate, the air supply device 100 may spray cold air to the tub 2, and in the state in which the heating device operates, the air supply device 100 may spray hot air to the tub 2. Hereafter, the air supply device 100 spraying hot air is described, unless mentioned otherwise.

The air supply device 100 may include a housing 110, an air blowing fan 120, a heating part 130 and an air discharge part 140. A flow path through which air flows may be formed in the hosing 110. The air blowing fan 120 may be mounted in the housing 110 and force air flowing into the housing to flow.

The air blowing fan 120 may be controlled and rotated by a controller provided at the dishwasher 1. The air blowing fan 120 may be mounted in the housing 110, and may include a fan forcing air to flow, and a bracket having a corresponding structure to the air blowing fan 120 on which the fan is rotatably mounted.

The air blowing fan 120 may include an air inlet 121 into which external air flows. The air inlet 121 may be formed to allow air to flow in a parallel with the rotation axis of the air blowing fan 120. The air inlet 121 may be formed in a way that a hole is made at the bracket of the air blowing fan 120.

The heating part 130 may be at least partially disposed in the housing 110 and heat the air that is forced to flow by the air blowing fan 120. The heating part 130 may be built into the housing 110, and the air, forced to flow by the air blowing fan 120, may be heated by the heating part 130 and become hot air while flowing in the housing 110.

The heating part 130, for example, may be an electric resistance heating coil, i.e., a sheath heater structure in which a coil receives electricity from a power source and is heated, but not limited. The end portion of the heating part 130 may be exposed to the outside of the housing 110 to electrically connect to the power source.

The air discharge part 140 may be mounted in the housing 110 and communicate with an air outlet of the housing 110, and guide the flow of air being discharged to the tub 2. The air discharge part 140 may have a hollow hole, through which air flows, therein and serve as a duct.

The air discharge part 140 may have a discharge outlet 141 through which air escapes, in the end portion thereof. The discharge outlet 141 may communicate with the inside of the tub 2. Accordingly, air having escaped from the discharge outlet 141 may flow into the tub 2 and be diffused in the tub 2.

Air forced to flow by the air blowing fan 120 may flow as follows. As the air blowing fan 120 operates, air may flow into the air blowing fan 120 through the air inlet 121 of the air blowing fan 120.

The air having passed through the air blowing fan 120 may flow into the housing 110 communicating with the air blowing fan 120, be heated by the heating part 130 disposed in the housing 110, be discharged from the housing 110 and flow into the air discharge part 140. Air discharged from the discharge outlet 141 of the air discharge part 140 may flow into the tub 2 and supply hot air to the tub 2.

Referring to FIG. 9, the housing 110 may be provided with a first piece 111, a second piece 112, a first bracket 113, a second bracket 114, a mounting bracket 115 and a support part 116.

The first piece 111 may have space that accommodates the heating part 130. The second piece 112 may close inner space of the first piece 111. After the heating part 130 is mounted on the first piece 111, the second piece 112 may close the inner space of the first piece 111 on which the heating part 130 is mounted. The first piece 111 and the second piece 112 may be coupled to each other by a coupling tool such as a screw bolt and the like, for example.

The first bracket 113 may be coupled to the inner wall of the first piece 111 and mounted in the inner space of the first piece 111. The heating part 130 may be mounted on the first bracket 113 and stably mounted in the housing 110.

The second bracket 114 may have a pair of through holes, and both end portions of the heating part 130 may be inserted respectively into the pair of through holes. The second bracket 114 may be assembled and fitted into a depression groove formed at the first piece 111. Accordingly, the end portion of the heating part 130 may be exposed out of the housing 20 and connect to an external power source.

The mounting bracket 115 may be formed in the portion where the first piece 111 and the air blowing fan 120 are coupled, and the air blowing fan 120 may be coupled to the mounting bracket 115 to communicate with the housing 110. The support part 116 may protrude from the lower surface of the first piece 111, and the lower surface of the support part 116 may be placed on the bottom plate 81 of the base 8.

The support part 116 may support the air supply device 100 entirely. Additionally, the support part 116 may space the heating part 130 disposed at the air blowing fan 120 and the housing 110 upward from the bottom plate 81 of the base 8, such that wash water having flown into the bottom plate 81 and collected on the bottom plate 81 is prevented from flowing into the heating part 130 and the air blowing fan 120. Thus, the submergence of the heating part 130 and the air blowing fan 120 may be suppressed.

The air supply device 100 may further include a fuse device 150. The fuse device 150 may be mounted on the first piece 111, and detect the overheating of the heating part 130. The fuse device 150 may serve as a thermostat in which an inner circuit is cut when the temperature of the heating part 130 increases to a predetermined threshold temperature or greater.

In this case, as the inner circuit of the fuse device 150 is cut, the supply of power to the heating part 130 is cut off immediately to stop the operation of the heating part 130 that is overheated.

FIG. 12 is a view showing that some components in FIG. 4 are disassembled. Hereafter, the subject matter of the present disclosure is described with reference to FIGS. 5 and 12.

Referring to FIG. 5, since the air supply device 100 and the air supply control module 200 are separated and spaced from each other in the front-rear direction of the base 8 as described above, the overheating of the air supply control module 200, caused by a direct transfer of heat, which is generated in the heating part 130 provided in the housing 110 of the air supply device 100, to the air supply control module 200, may be suppressed effectively.

The air inlet 121 of the air blowing fan 120 may be disposed in a position where the air inlet 121 overlaps the air supply control module 200 in the front-rear direction of the base 8. The air supply control module 200 may have a vent hole 210. Since external air flows into air supply control module 200 through the vent hole 210, the air supply control module 200 may be cooled by the air, and prevented from overheating.

The vent hole 210 may be formed on the front surface of the air supply control module 200, in other words, formed on a wall of the cuboid-shaped air supply control module 200, facing the air blowing fan 120, in a way that passes through the wall, for example. In this case, a plurality of vent holes 210 may be provided.

The vent hole 210 has a slit shape in the embodiment, but not be limited. The vent hole 210 may have a different shape as long as the vent hole allows air to pass smoothly.

In the structure, as the air blowing fan 120 operates, air flowing in the front-rear direction of the base 8 may smoothly flow into the air supply control module 200 through the vent hole 210 formed on the front surface of the air supply control module 200.

The air inlet 121 of the air blowing fan 120 may be formed to face the front of the base 8. A wall of the air blowing fan 120, facing the front of the base 8, may have the air inlet 121, while a wall of the air blowing fan 120, facing the rear of the base 8, may not have a through hole and be closed. In the structure, as the air blowing fan 120 operates, air near the air blowing fan 120 may be forced to flow from the front of the base 8 to the rear of the base 8.

Accordingly, as the air blowing fan 120 operates, air adjacent to the air inlet 121, in the base 8, may move in the front-rear direction of the base 8 as indicated by the arrows of FIG. 5, to move to the air inlet 121.

Thus, the air blowing fan 120 may force external air to flow in the front-rear direction of the base 8 and allow the air to be suctioned into the air inlet 121.

Air near the air blowing fan 120 may flow in the front-rear direction of the base 8 as the air blowing fan 120 operates. A portion of the air flowing in the front-rear direction of the base 8 may flow into the vent hole 210 of the air supply control module 200 by the air blowing fan 120.

Referring to FIG.5, a portion of the air forced to flow by the air blowing fan 120 may flow into the air supply device 100 through the air inlet 121, and a portion of the air may pass the air blowing fan 120, move to the rear side of the base 8 and flow to the air supply control module 200 disposed behind the air blowing fan 120.

Since all the air, which is forced to flow as the air blowing fan 120 operates, does not flow to the air inlet 121, air, which is forced to flow but does not flow to the air inlet 121, may pass the air blowing fan 120 and move to the rear side of the base 8.

The air reaching the air supply control module 200 may flow into the air supply control module 200 through the vent hole 210 formed at the front of the air supply control module 200, and cool the circuit board and the elements and the like in the air supply control module 200 and effectively suppress their overheating.

In conclusion, the air supply control module 200 and the air blowing fan 120 in the embodiment may be disposed to overlap each other in the front-rear direction of the base 8, such that a portion of the air forced to flow by the air blowing fan 120 flows into the air supply control module 200 and cools the components in the air supply control module 200. Thus, the overheating of the air supply control module 200, which is caused when the dishwasher 1 operates, may be suppressed effectively.

## Claims

1. A dishwasher (1), comprising:
a tub (2) forming wash space (21) and configured to accommodate objects to be washed;
a base (8) being disposed under the tub (2);
a door (3) being configured to open and close the wash space (21);
a sump (4) being disposed under the tub (2) and configured to store wash water;
an air supply device (100) comprising a housing, an air blowing fan and an air discharge part,
and being disposed at the base (8) and configured to spray air to the tub (2);
wherein the door (3) is disposed in front of the sump (4) in a front-rear direction of the base (8);
wherein the air supply device (100) is disposed behind the sump (4) in the front-rear direction of the base (8);
wherein the dishwasher (1) further comprises an air supply control module (200) that is disposed in the base (8), is electrically connected to the air supply device (100) and controls operations of the air supply device (100);
**characterized in that** the air supply control module (200) is disposed behind the air supply device (100) and spaced from the air supply device (100);
wherein the air supply control module (200) is disposed on a wall over a bottom plate (81) of the base (8) and so it is configured to be spaced from the bottom plate (81); and
wherein the wall comprises:
a first wall (82) bending from the bottom plate (8) at least partially in an up-down direction,
a second wall (83) bending from the first wall (82) at least partially in a front-rear direction and sitting in the air supply control module (200), and
a rear wall (84) bending from the second wall (83) at least partially in the up-down direction.

2. The dishwasher (1) of claim 1, wherein a lengthwise direction of the air supply device (100) is parallel with a lateral direction of the base (8).

3. The dishwasher (1) of claim 1 or claim 2, wherein the second wall (83) comprises:
a flat part (831) having an upper surface, which is formed in a parallel direction with a front-rear direction and a left-right direction of the base (8) and on which a lower surface of the air supply control module (200) is placed, and having a first fastening hole (8311), which is configured such that a coupling tool for a coupling with the air supply control module (200) can be inserted;
a first connection part (832) connecting the first wall (82) and the flat part (831); and
a second connection part (833) connecting the rear wall (84) and the flat part (831).

4. The dishwasher (1) according to any one of claims 1 to 3, wherein the rear wall (84) has a coupling protrusion part (841) protruding forward from the rear wall (84), contacting one surface of the air supply control module (200), and having a second fastening hole (8411) configured such that a coupling tool for a coupling with the air supply control module (200) can be inserted.

5. The dishwasher (1) according to any one of claims 1 to 4, wherein the air supply device (100) comprises:
a housing (110) having a flow path through which air flows;
an air blowing fan (120) being mounted in the housing (110) and forcing air flowing into the housing (110) to flow;
a heating part (130) being disposed in the housing (100) at least partially and being capable of heating
air forced to flow by the air blowing fan (120); and
an air discharge part (140) being mounted in the housing (110), communicating with an air outlet of the housing (110), and guiding a flow of air being discharged to the tub (2).

6. The dishwasher (1) according to claim 5, wherein the air blowing fan (120) comprises an air inlet (121) into which external air flows, and
the air inlet (121) is disposed to overlap the air supply control module (200) in the front-rear direction of the base (8).

7. The dishwasher (1) of claim 6, wherein the air supply control module (200) has a vent hole (210) on a front surface thereof, and
the air blowing fan (120) forces external air to flow in the front-rear direction of the base (8) and allows the air to be suctioned into the air inlet (121).

8. The dishwasher (1) of claim 7, wherein the flow path is formed such that air near the air blowing fan (120) flows in the front-rear direction of the base (8) as the air blowing fan (120) operates, and
a portion of the air, forced to flow by the air blowing fan (120) in the front-rear direction of the base (8), flows into the vent hole (210) of the air supply control module (200).

9. The dishwasher (1) according to any one of claims 1 to 8, further comprising a balance weight (300) being disposed behind the sump (4), being disposed at the base (8), and being configured to suppress an overturning of the dishwasher.

10. The dishwasher of claim 9, wherein the balance weight (300) is spaced from the air supply device (100) in a lateral direction of the base (8).

## Patentansprüche

1. Geschirrspüler (1), der aufweist:
einen Bottich (2), der einen Spülraum (21) bildet und konfiguriert ist, die zu spülenden Objekte aufzunehmen;
eine Basis (8), die unter dem Bottich (2) angeordnet ist;
eine Tür (3), die konfiguriert ist, den Spülraum (21) zu öffnen und zu schließen;
einen Sumpf (4), der unter dem Bottich (2) angeordnet und konfiguriert ist, Spülwasser zu speichern;
eine Luftzufuhrvorrichtung (100), die ein Gehäuse, ein Luftgebläse und einen Luftabgabeteil aufweist und an der Basis (8) angeordnet und konfiguriert ist, Luft zum Bottich (2) zu sprühen;
wobei die Tür (3) vor dem Sumpf (4) in einer Vorwärts-Rückwärts-Richtung der Basis (8) angeordnet ist;
wobei die Luftzufuhrvorrichtung (100) hinter dem Sumpf (4) in der Vorwärts-Rückwärts-Richtung der Basis (8) angeordnet ist;
wobei der Geschirrspüler (1) ferner ein Luftzufuhr-Steuermodul (200) aufweist, das in der Basis (8) angeordnet ist, elektrisch mit der Luftzufuhrvorrichtung (100) verbunden ist und den Betrieb der Luftzufuhrvorrichtung (100) steuert;
**dadurch gekennzeichnet, dass**
das Luftzufuhr-Steuermodul (200) hinter der Luftzufuhrvorrichtung (100) und beabstandet von der Luftzufuhrvorrichtung (100) angeordnet ist;
wobei das Luftzufuhr-Steuermodul (200) an einer Wand über einer Bodenplatte (81) der Basis (8) angeordnet ist und so konfiguriert ist, dass es von der Bodenplatte (81) beabstandet ist; und wobei die Wand aufweist:
eine erste Wand (82), die sich von der Bodenplatte (8) zumindest teilweise in einer Aufwärts-Abwärts-Richtung biegt,
eine zweite Wand (83), die sich von der ersten Wand (82) zumindest teilweise in einer Vorwärts-Rückwärts-Richtung biegt und im Luftzufuhr-Steuermodul (200) sitzt, und
eine Rückwand (84), die sich von der zweiten Wand (83) zumindest teilweise in der Aufwärts-Abwärts-Richtung biegt.

2. Geschirrspüler (1) nach Anspruch 1, wobei eine Längsrichtung der Luftzufuhrvorrichtung (100) parallel zu einer lateralen Richtung der Basis (8) verläuft.

3. Geschirrspüler (1) nach Anspruch 1 oder Anspruch 2, wobei die zweite Wand (83) aufweist:
einen flachen Teil (831), der eine Oberseite aufweist, die parallel zu einer Vorwärts-Rückwärts-Richtung und einer Links-Rechts-Richtung der Basis (8) ausgebildet ist und auf der eine Unterseite des Luftzufuhr-Steuermoduls (200) angeordnet ist, und ein erstes Befestigungsloch (8311) aufweist, das so konfiguriert ist, dass ein Kopplungswerkzeug für eine Kopplung mit dem Luftzufuhr-Steuermodul (200) eingesetzt werden kann;
einen ersten Verbindungsteil (832), der die erste Wand (82) und den flachen Teil (831) verbindet; und einen zweiten Verbindungsteil (833), der die Rückwand (84) und den flachen Teil (831) verbindet.

4. Geschirrspüler (1) nach einem der Ansprüche 1 bis 3, wobei die Rückwand (84) einen Kopplungsvorsprungsteil (841) aufweist, der von der Rückwand (84) nach vorne vorsteht, eine Oberfläche des Luftzufuhr-Steuermoduls (200) berührt und ein zweites Befestigungsloch (8411) aufweist, das so konfiguriert ist, dass ein Kopplungswerkzeug für eine Kopplung mit dem Luftzufuhr-Steuermodul (200) eingesetzt werden kann.

5. Geschirrspüler (1) nach einem der Ansprüche 1 bis 4, wobei die Luftzufuhrvorrichtung (100) aufweist:
ein Gehäuse (110) mit einem Strömungsweg, durch den Luft strömt;
ein Luftgebläse (120), das im Gehäuse (110) angebracht ist und in das Gehäuse (110) strömende Luft zum Strömen zwingt;
einen Heizteil (130), der zumindest teilweise in dem Gehäuse (100) angeordnet ist und imstand ist, Luft zu erwärmen, die durch das Luftgebläse (120) zum Strömen gezwungen wird; und
ein Luftabgabeteil (140), das im Gehäuse (110) angebracht ist, mit einem Luftauslass des Gehäuses (110) in Verbindung steht und einen Luftstrom leitet, der zum Bottich (2) abgegeben wird.

6. Geschirrspüler (1) nach Anspruch 5, wobei das Luftgebläse (120) einen Lufteinlass (121) aufweist, in den Außenluft einströmt, und
der Lufteinlass (121) so angeordnet ist, dass er das Luftzufuhr-Steuermodul (200) in der Vorwärts-Rückwärts-Richtung der Basis (8) überlappt.

7. Geschirrspüler (1) nach Anspruch 6, wobei das Luftzufuhr-Steuermodul (200) an seiner Vorderseite ein Entlüftungsloch (210) aufweist, und
das Luftgebläse (120) die Außenluft zwingt, in die Vorwärts-Rückwärts-Richtung der Basis (8) zu strömen, und es ermöglicht, dass die Luft in den Lufteinlass (121) gesaugt wird.

8. Geschirrspüler (1) nach Anspruch 7, wobei der Strömungsweg so ausgebildet ist, dass die Luft in der Nähe des Luftgebläses (120) in die Vorwärts-Rückwärts-Richtung der Basis (8) strömt, wenn das Luftgebläse (120) arbeitet, und
ein Teil der Luft, die durch das Luftgebläse (120) gezwungen wird, in der Vorwärts-Rückwärts-Richtung der Basis (8) zu strömen, in das Entlüftungsloch (210) des Luftzufuhr-Steuermoduls (200) strömt.

9. Geschirrspüler (1) nach einem der Ansprüche 1 bis 8, der ferner ein Ausgleichsgewicht (300) aufweist, das hinter dem Sumpf (4) angeordnet, an der Basis (8) angeordnet und konfiguriert ist, ein Umkippen des Geschirrspülers zu verhindern.

10. Geschirrspüler nach Anspruch 9, wobei das Ausgleichsgewicht (300) in einer lateralen Richtung der Basis (8) von der Luftzufuhrvorrichtung (100) beabstandet ist.

## Revendications

1. Lave-vaisselle (1), comprenant :
une cuve (2) formant un espace de lavage (21) et prévue pour recevoir des objets à laver ;
une base (8) disposée sous la cuve (2) ;
une porte (3) prévue pour ouvrir et fermer l'espace de lavage (21) ;
un puisard (4) disposé sous la cuve (2) et prévu pour stocker de l'eau de lavage ;
un dispositif de refoulement d'air (100) comprenant un boîtier, un ventilateur de soufflage d'air et une partie de refoulement d'air, disposé sur la base (8) et prévu pour vaporiser de l'air dans la cuve (2) ;
où la porte (3) est disposée devant le puisard (4) dans la direction de l'avant vers l'arrière de la base (8) ;
où le dispositif de refoulement d'air (100) est disposé derrière le puisard (4) dans la direction de l'avant vers l'arrière de la base (8) ;
où ledit lave-vaisselle (1) comprend en outre un module de commande de refoulement d'air (200) disposé dans la base (8), est connecté électriquement au dispositif de refoulement d'air (100) et commande les opérations du dispositif de refoulement d'air (100) ;
**caractérisé en ce que**
le module de commande de refoulement d'air (200) est disposé derrière le dispositif de refoulement d'air (100) et est espacé du dispositif de refoulement d'air (100) ;
le module de commande de refoulement d'air (200) étant disposé sur une paroi au-dessus d'une plaque inférieure (81) de la base (8) et étant ainsi prévu de manière à être espacé de la plaque inférieure (81) ; et
où la paroi comprend :
une première paroi (82) pliée depuis la plaque de fond (8) au moins partiellement dans la direction du bas vers le haut,
une deuxième paroi (83) pliée depuis la première paroi (82) au moins partiellement dans la direction de l'avant vers l'arrière et reposant dans le module de commande de refoulement d'air (200), et
une paroi arrière (84) pliée depuis la deuxième paroi (83) au moins partiellement dans la direction du bas vers le haut.

2. Lave-vaisselle (1) selon la revendication 1, où la direction longitudinale du dispositif de refoulement d'air (100) est parallèle à la direction latérale de la base (8).

3. Lave-vaisselle (1) selon la revendication 1 ou la revendication 2, où la deuxième paroi (83) comprend :
une partie plane (831) présentant une surface supérieure, formée dans une direction parallèle à la direction de l'avant vers l'arrière et la direction de gauche à droite de la base (8), et sur laquelle est disposée une surface inférieure du module de commande de refoulement d'air (200), et ayant un premier trou de fixation (8311), prévu de manière à permettre l'insertion d'un outil d'accouplement pour un accouplement avec le module de commande de refoulement d'air (200) ;
une première partie de connexion (832) reliant la première paroi (82) et la partie plane (831) ; et une deuxième partie de connexion (833) reliant la paroi arrière (84) et la partie plane (831).

4. Lave-vaisselle (1) selon l'une des revendications 1 à 3, où la paroi arrière (84) présente une partie d'accouplement saillante (841) faisant saillie vers l'avant depuis la paroi arrière (84), en contact avec une surface du module de commande de refoulement d'air (200), et présentant un deuxième trou de fixation (8411), prévu de manière à permettre l'insertion d'un outil d'accouplement pour un accouplement avec le module de commande de refoulement d'air (200).

5. Lave-vaisselle (1) selon l'une des revendications 1 à 4, où le dispositif de refoulement d'air (100) comprend :
un boîtier (110) présentant une voie d'écoulement par laquelle s'écoule l'air ;
un ventilateur de soufflage d'air (120) monté dans le boîtier (110) et forçant la circulation de l'air s'écoulant dans le boîtier (110) ;
une partie chauffante (130) disposée au moins en partie dans le boîtier (100) et apte à chauffer l'air dont la circulation est forcée par le ventilateur de soufflage d'air (120) ; et
une partie de refoulement d'air (140) montée dans le boîtier (110), communiquant avec une sortie d'air du boîtier (110), et guidant un flux d'air refoulé vers la cuve (2).

6. Lave-vaisselle (1) selon la revendication 5, où le ventilateur de soufflage d'air (120) comprend une entrée d'air (121) par où s'écoule de l'air extérieur, et
où l'entrée d'air (121) est disposée de manière à chevaucher le module de commande de refoulement d'air (200) dans la direction de l'avant vers l'arrière de la base (8).

7. Lave-vaisselle (1) selon la revendication 6, où le module de commande de refoulement d'air (200) présente un orifice d'aération (210) sur sa surface avant, et
où le ventilateur de soufflage d'air (120) force l'air extérieur à circuler dans la direction de l'avant vers l'arrière de la base (8) et permet l'aspiration d'air dans l'entrée d'air (121).

8. Lave-vaisselle (1) selon la revendication 7, où la voie d'écoulement est formée de sorte que l'air à proximité du ventilateur de soufflage d'air (120) s'écoule dans la direction de l'avant vers l'arrière de la base (8) lorsque le ventilateur de soufflage d'air (120) fonctionne, et
où une partie de l'air, forcé à s'écouler par le ventilateur de soufflage d'air (120) dans la direction de l'avant vers l'arrière de la base (8), s'écoule dans l'orifice d'aération (210) du module de commande de refoulement d'air (200).

9. Lave-vaisselle (1) selon l'une des revendications 1 à 8, comprenant en outre un poids d'équilibrage (300) disposé derrière le puisard (4), disposé sur la base (8), et prévu pour empêcher un basculement du lave-vaisselle.

10. Lave-vaisselle selon la revendication 9, où le poids d'équilibrage (300) est espacé du dispositif de refoulement d'air (100) dans la direction latérale de la base (8).
